# EUROPEAN PATENT SPECIFICATION

(11) **EP 1 568 471 B1**
(45) Date of publication and mention of the grant of the patent: **20.03.2013**
(21) Application number: 03758957.9
(22) Date of filing: 27.10.2003
(51) Int. Cl.: B29C 65/44, B32B 37/06

(54) **HEAT-RESISTANT FLEXIBLE LAMINATED BOARD MANUFACTURING METHOD**
VERFAHREN ZUR HERSTELLUNG EINER WÄRMEBESTÄNDIGEN FLEXIBEL LAMINIERTEN PLATTE
PROCEDE DE FABRICATION D'UN CONTRE-PLAQUE SOUPLE RESISTANT A LA CHALEUR

(30) Priority: 07.11.2002 JP 2002323966
(43) Date of publication of application: 31.08.2005
(73) Proprietor: KANEKA CORPORATION, Osaka (JP)
(72) Inventor: HASE, Naoki, Otsu-shi, Shiga 520-0104 (JP); MATSUKUBO, Shinji, Otsu-shi, Shiga 520-0105 (JP); TSUJI, Hiroyuki, Yokohama-shi, Kanagawa 227-0062 (JP); FUSHIKI, Yasuo, Yamashina-ku, Kyoto 607-8084 (JP)
(74) Representative: Brown, Fraser Gregory James
(86) International application number: PCT/JP2003/013739
(87) International publication number: WO 2004/041517

(56) References cited:
- WO-A-01/32418
- WO-A1-01/32418
- JP-A- 2001 252 978
- JP-A- 2002 283 517
- JP-B2- 7 085 923
- US-A- 3 027 285

## Description

### TECHNICAL FIELD

The present invention relates to a method of producing a laminate, which comprises continuously laminating a heat-resistant film having thermal fusibility with a metallic foil. More particularly, the present invention relates to a method of producing a laminate for use in the production of electronic and electric equipments.

### BACKGROUND ART

Laminates for use in the formation of printed circuit boards for electronic and electric equipments includes, for example, laminates comprising metallic foils bonded with a thermosetting adhesive made of a thermosetting resin (hereinafter referred to as thermosetting laminates) and laminates comprising metallic foils bonded with a thermally fusible adhesive made of a thermoplastic resin (hereinafter referred to as thermally fusible laminates).

Various methods of producing thermosetting laminates have hitherto been studied. Examples thereof include a method of pressing a resin-impregnated paper or glass cloth with metallic foils, using a multistage press or a vacuum press and then thermally curing the resin at high temperature for several hours to obtain a rigid laminate, a method of laminating a roll-shaped material while being interposed between a pair of heated roll laminating apparatuses (thermal laminating apparatuses) and then thermally curing the material at high temperature for several hours to obtain a rigid laminate, and a method of thermally laminating using a double-belt press in place of the thermal laminating apparatus.

These thermosetting laminates are usually produced by forming under pressure at a temperature of 200°C or lower. Small thermal stress is applied on a laminating material at such a low heating temperature, and therefore less adverse influence is exerted on appearance of the laminates.

On the other hand, in the production of the thermally fusible laminates, thermal fusion can not be achieved under pressure unless the heating temperature is higher than a glass transition temperature (Tg) of a thermoplastic resin constituting a bonding layer. Since the laminates for electronic and electric equipments are heated to high temperature in the process of packaging of parts, Tg of at least 180°C is required to the thermoplastic resin constituting the bonding layer. Furthermore, thermal fusion of the resin requires thermal lamination at a temperature of not lower than 200°C. For example, aforementioned descriptions are disclosed in Japanese Unexamined Patent Publication (Kokai) No. 4-33848, Japanese Unexamined Patent Publication (Kokai) No. 11-300887, Japanese Patent No. 2652325, and Japanese Unexamined Patent Publication (Kokai) No. 9-116254.

Since these laminates are exposed to high temperature in the lamination process and may be adversely affected by various forces, there arises a so-called "end waviness" phenomenon wherein the ends of the resulting laminate are in a wavy state. End waviness wherein the ends of the laminate are not in a flat state causes such a problem that the laminate can not be satisfactorily fixed by evacuation from the back side of the laminate to cause pattern deviation when a circuit pattern is formed by applying a photoresist on the laminate, followed by exposure, development and further copper foil etching.

WO-A-01/32418 discloses a method of manufacturing a laminated plate which is free from visual defects by the use of a thermally resistant protective material between a pressing surface and the laminated materials.

### DISCLOSURE OF THE INVENTION

An object of the present invention is to solve such a problem that pattern deviation may be caused by end waviness of the heat-resistant flexible laminate in the process for formation of a circuit and to provide a heat-resistant flexible laminate having good appearance.

A mechanism for production of end waviness is not sure, but is considered as follows. In the cooling process after laminating the laminating materials at high temperature under pressure, the temperature of the ends decreases prior to the center portion to cause a difference in temperature between the ends and center portion. Since the amount of contraction of the laminate varies with the temperature, the ends contract drastically as compared with the center portion. In case the laminate is continuously produced, a force of taking up the laminate, i.e. take-up tension is applied to the laminate. In case the take-up tension is applied in the cooling process in the state where the ends contract drastically as compared with the center portion, the ends are extended to cause plastic deformation. When cooled to normal temperature, the ends are loosened as a result of plastic deformation, and thus there arises a so-called "end waviness" phenomenon wherein the ends of the laminate are in a wavy state.

The present inventors have intensively studied about a method of controlling end waviness of the laminate and, as a result, the present invention has been completed.

The present invention is directed to a method of producing a laminate, as defined in claim 1.

In preferable embodiment, the present invention is directed to aforementioned method, wherein the temperature of the ends is 40°C higher than that of the center portion.

In more preferable embodiment, the present invention is directed to any one of aforementioned methods, which comprises laminating using a heated roll laminating apparatus.

In more preferable embodiment, the present invention is directed to any one of aforementioned methods, which comprises disposing a protective material between the pressing surface of the heated roll laminating apparatus and a laminating material, thermally laminating them aL 200°C or higher, thereby to slightly contact the protective material with the laminating material, and removing the protective material from the laminate after cooling the laminate.

In more preferable embodiment, the present invention is directed to any one of aforementioned methods, wherein the heat-resistant film having thermal fusibility comprises a non-thermoplastic polyimide film and a resin containing a thermally fusible component provided on the surface of the non-thermoplastic polyimide film.

In more preferable embodiment, the present invention is directed to any one of aforementioned methods, wherein the thermally fusible component of the heat-resistant film contains a thermoplastic polyimide in an amount of 50% by weight or more based on 100% by weight of the thermally fusible component.

In more preferable embodiment, the present invention is directed to any one of aforementioned methods, wherein the metallic foil is a copper foil having a thickness of 50 µm or less.

In more preferable embodiment, the present invention is directed to any one of aforementioned methods, wherein the protective material is a non-thermoplastic polyimide film.

### BRIEF DESCRIPTION OF THE DRAWINGS

Fig. 1 is a schematic diagram showing a thermal laminating apparatus.
Fig. 2 is a schematic diagram showing a heater for controlling end waviness.
Fig. 3 is a diagram showing a state of waviness.

### Brief Description of the Reference Symbols

- 1:: Copper foil
- 2:: Heat-resistant film having thermal fusibility
- 3:: Protective material
- 4:: Heated roll laminating apparatus
- 5:: Protective material take-up apparatus
- 6:: Product take-up apparatus
- 7:: Heater for controlling end waviness
- 8:: Far infrared heater
- 9:: Sample

### BEST MODE FOR CARRYING OUT THE INVENTION

The present invention will now be described in detail.

The laminate obtained by the method of the present invention can be preferably used as a flexible laminate for electronic and electric equipments, though applications thereof are not specifically limited.

Examples of the heat-resistant film having thermal fusibility in the present invention include a single-layer film made of a resin having thermal fusibility, a multi-layer film comprising a core layer having no thermal fusibility and a resin layer having thermal fusibility formed on either or both sides of the core layer, and a film comprising a base material made of paper or glass cloth impregnated with a resin having thermal fusibility. Since the resulting film is inferior in flexibility when using a base material having rigidity such as glass cloth, the film for heat-resistant flexible laminate is particularly preferably a single-layer filmmade of a resinhaving thermal fusibility, or amulti-layer film comprising a core layer having no thermal fusibility and a resin layer having thermal fusibility formed on either or both sides of the core layer.

The term "thermal fusibility" as used herein means a property wherein elastic modulus of the film is lowered by heating to the temperature of higher than a glass transition temperature (Tg), thus making it possible to laminate with a laminating material. The term "heat resistance" as used herein means a property capable of enduring continuous duty at the temperature of not lower than 200°C.

Examples of the resin having thermal fusibility include polyethylene, polystyrene, polypropylene, polyester, poly(meth)acrylate, and thermoplastic polyimide. Among these resins, resins containing a thermoplastic polyimide component, for example, thermoplastic polyamideimide, thermoplastic polyether imide, thermoplastic polyester imide or the like can be preferably used in view of heat resistance. The content of the thermoplastic polyimide is preferably 50% by weight or more, and more preferably 70% by weight or more, based on 100% by weight of the thermal fusibility component. To improve adhesion, the thermal fusibility component may contain a thermosetting resin such as epoxy resin, phenol resin, or an acrylic resin having a reactive group. To improve various properties, the thermally fusible component may contain various additives.

The heat-resistant film having thermal fusibility in the present invention is not specifically limited as long as it has a heat-resistant and thermally fusible resin layer as an outermost layer. For example, the heat-resistant film may be a single-layer composed only of a thermally fusible resin, but is preferably a three-layer structure film comprising a core layer having no thermal fusibility and a resin layer having thermal fusibility provided on both sides of the core layer in view of dimensional stability. A two-layer structure film comprising a core layer having no thermal fusibility and a resin layer having thermal fusibility provided on one side of the core layer can also be used. In case of the two-layer structure film, no thermally fusible layer is preferably provided on the side, on which a thermally fusible layer is not provided, in order to prevent warp after laminating a metallic foil.

The core layer having no thermal fusibility is not specifically limited as long as it has heat resistance and examples thereof include non-thermoplastic polyimide film, aramid film, polyether ether ketone film, polyether sulfone film, polyallylate film, and polyethylene naphthalate film. Among these films, a non-thermoplastic polyimide film is preferable in view of electrical characteristic.

Preferable examples of the heat-resistant film in the present invention include a film comprising a non-thermoplastic polyimide film and a layer made of thermoplastic polyimide provided on either or both sides of the non-thermoplastic polyimide film.

The method of forming the heat-resistant film having thermal fusibility in the present invention is not specifically limited. In case the heat-resistant film is a single-layer film containing a resin having thermal fusibility, a film can be formed by a belt-cast method or an extrusion method. In case the heat-resistant film having thermal fusibility comprises three layers of a thermally fusible layer, a core layer having no thermal fusibility and a thermally fusible layer, there can be used a method of applying a resin having thermal fusibility on both sides of a core layer having no thermal fusibility (for example, heat-resistant film) separately or simultaneously to form a three-layer film, and a method of laminating a resin layer having thermal fusibility on both sides of a heat-resistant film to form a three-layer film. In the method of forming a three-layer film by applying a resin having thermal fusibility, when using thermoplastic polyimide as a thermally fusible component, there can be used a method of applying a resin in a state of polyamic acid as a precursor on a heat-resistant film and imidating the polyamic acid while drying, and a method of directly applying a soluble polyimide resin and drying the resin, and a method of forming a thermally fusible layer is not specifically limited. In addition to these methods, there is a method of simultaneously extruding a resin for thermally fusible layer, a resin for core layer having no thermal fusibility and a resin for thermally fusible layer to form a heat-resistant film having thermal fusibility.

Examples of the metallic foil in the present invention include, but are not limited to, copper foil, aluminum foil, and SUS foil. Among these metallic foils, a copper foil is preferable used in view of conductivity and cost in case of a laminate for use in the production of electronic and electric equipments. The thickness of the copper foil is preferably 50 µm or less because smaller line width of a circuit pattern can be achieved as the thickness of the copper foil decreases. Since the copper foil having a thickness of 18 µm or less is less elastic than the copper foil having a greater thickness and wrinkles may be produced during thermal lamination. Therefore, the present invention exerts a remarkable effect when using a copper foil having a thickness of 18 µm or less. Examples of the copper foil include, but are not limited to, rolled copper foil and electrolytic copper foil. The surface of these copper foils may be coated with an adhesive made of a resin having thermal fusibility.

In the present invention, the apparatus for continuously laminating the heat-resistant film having thermal fusibility with the metallic foil is not specifically limited as long as it is an apparatus capable of thermally pressuring, and examples thereof include single-action press, vacuum press, autoclave apparatus, heated roll laminating apparatus, and double-belt press. Among these apparatuses, heated roll laminating apparatus and double-belt press are preferable because they are suited for continuous production. As compared with batch production, continuous production enables an improvement in productivity and a reduction of loss.

The heated roll laminating apparatus is not specifically limited as long as it is an apparatus for thermally pressurizing laminating materials. Heating method is not specifically limited as long as it can heat at a predetermined temperature and examples thereof include heating medium circulating system, hot-air heating system, and dielectric heating system. The heating temperature is preferably 200°C or higher. When used for application wherein a laminate is passed through a solder reflow furnace at an atmospheric temperature of 240 °C for the purpose of packaging electronic parts, the heating temperature is 240°C or higher because a heat-resistant film containing a thermally fusible component having predetermined Tg is used. Examples of the material of the press roll include, but are not limited to, rubber and metal. In case the lamination temperature reaches high temperature such as 280°C or higher, the rubber roll can not be used because the rubber deteriorates. In such a case, a metal roll is preferably used. The pressuring system is not specifically limited as long as it can apply a predetermined pressure, and examples thereof include oil hydraulic system, pneumatic system, and pressure system between gaps. The pressure is not specifically limited.

The protective material in the present invention is not specifically limited as long as it can play a role of preventing poor appearance such as wrinkles of the laminate product and examples thereof include paper, metallic foil, and plastic film. Among these materials, a plastic film is preferable in view of utility and cost. Furthermore, heat-resistant films such as non-thermoplastic polyimide film, aramid film, polyether ether ketone film, polyether sulfone film, polyallylate film, or polyethylene naphthalate film are preferable because they endure the temperature upon processing. In case of processing at 250°C, a heat-resistant film having more excellent heat resistance must be used and therefore a non-thermoplastic polyimide film is preferable.

The thickness of the protective material is not specifically limited, but is preferably 50 µm or more for the purpose of suppressing the formation of wrinkles of the laminate. The thickness of the protective material is more preferably 75 µm or more because the formation of wrinkles can be suppressed almost completely. The protective material is not necessarily subjected to a surface treatment as long as it slightly contacts with the laminating material, but may be optionally subjected to the surface treatment in order to suppress adhesion. As long as the surface treatment enables the protective material to slightly contact with the laminating material, the surface treatment may be applied for other purposes, for example, rust prevention treatment applied for the purpose of preventing oxidation of the surface. The state of slight contact as used herein means a state where the protective film and the laminating material are not mutually peeled off when any force is not applied, but they can be mutually peeled off by hands with ease.

The present invention is characterized in that the temperature of the ends of the laminate is the same as or higher than that of the center portion in the cooling process after lamination. The temperature of the center portion and the ends is controlled by a system having a mechanism capable of controlling the temperature of the center portion and the ends without any limitation. Examples thereof include heater system capable of controlling the temperature in a width direction, heated roll system, and heating oven system. The heater is not specifically limited as long as it can controlled to a predetermined temperature, and either far infrared heater or near infrared heater can be used.

The preset temperature of the heater is appropriately controlled by the distance from the laminate and intervals, and the surface temperature of the laminate is controlled within a range from 130°C to lamination temperature, preferably from 150°C to (lamination temperature - 50°C), and more preferably from 180°C to (lamination temperature - 100°C). When the surface temperature of the laminate is lower than the above range, contraction due to air cooling after lamination can not be reduced and the waviness-control effect may not be exerted. To the contrary, when the surface temperature is higher than the above range, the bonding layer reduces its elasticity, and thus adverse influence of the take-up tension may be exerted to cause plastic deformation, resulting in poor appearance. The surface temperature of the laminate can be measured by a thermocouple or a contact thermometer.

In view of the end waviness-control effect, difference in temperature between the center portion and the ends is preferably 40°C or higher, and more preferably 60°C or higher. When the difference in temperature is smaller than the above range, contraction of the ends may not be sufficiently reduced and the waviness-control effect may not be exerted.

Upper limit of the difference in temperature is preferably 150°C, and more preferably 120°C. When the upper limit of the difference in temperature exceeds the above value, the laminate is heated beyond heating required to compensate temperature drop of the ends. Therefore, the temperature of the center portion decreases and waviness may occur in the center portion of the laminate.

The present invention will be described in detail by way of examples, although the present invention is not limited to these examples in any sense.

### EXAMPLES

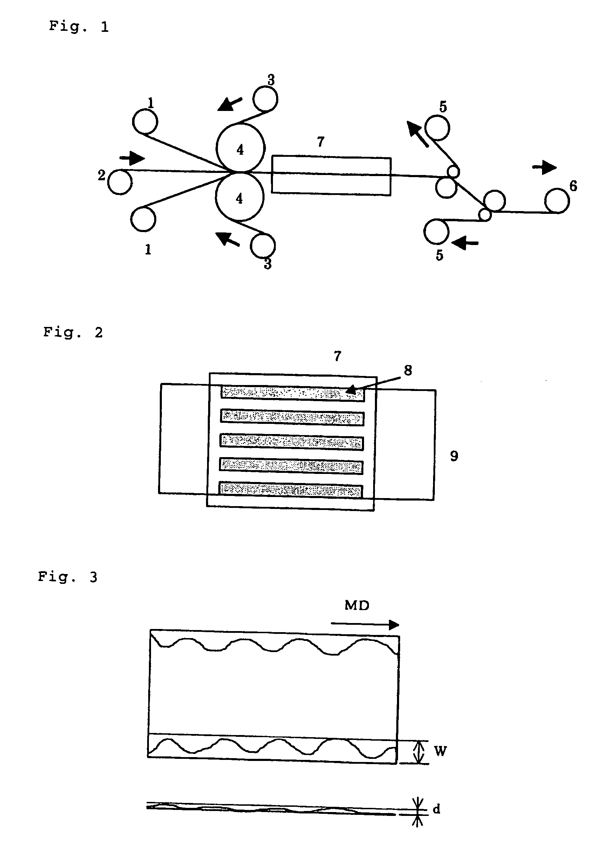

Glass transition temperature (Tg) in the Examples was measured in a nitrogen gas flowunder the conditions of a heating rate of 10°C/min and a temperature within a range from room temperature to 400°C using DSC CELL SCC-41 manufactured by Shimadzu Corporation (differentialscanning calorimetry). A thermal lamination apparatus with the configuration shown in Fig. 1 was used. To control the temperature in a width direction in the cooling process after lamination, a commercially available infrared heater was arranged to control the temperature of the ends and center portion of samples (see Fig. 2).

As shown in Fig. 3, the degree of end waviness was expressed by the width W (mm) of waviness and the height d (mm) of waviness. Degree of end waviness of samples was rated by the following criteria.
⊚ (Excellent): width (W) of waviness is 0
○ (Good): W is larger than 0 and smaller than 30 mm
Δ (Ordinary): W is larger than 30 mm and smaller than 60 mm
× (Poor): W is larger than 60 mm

### (Examples 1 to 3)

Each of flexible laminates was produced by disposing a three-layer structure film having a thickness of 25 µm and a width of 260 mm (PIXEO BP HC-142, manufactured by Kaneka Corporation) containing a thermoplastic polyimide resin component having Tg of 240°C on both sides of a non-thermoplastic polyimide film, disposing a 18 µm thick electrolytic copper foil (3EC-VLP, manufactured by Mitsui Metal Industrial Corp.) on both sides thereof, disposing a 125 µm thick polyimide film (APIKAL 125NPI, manufactured by Kaneka Corporation), as a protective film, on both sides thereof, laminating them under the conditions of a pass line shown in Fig. 1, a temperature of 380°C, a linear velocity of 2.0 m/min and a lamination pressure of 200 N/cm using a heated roll laminating apparatus, cooling to normal temperature in the state where the protective film slightly contacts with the flexible laminate, and removing the protective film from the flexible laminate. The conditions of difference in temperature between the ends and center portion of the laminate are shown in Table 1. The resulting flexible laminates have less waviness at the ends and good appearance.

### (Comparative Examples 1 and 2)

In the same manner as in Examples 1 to 3, except for the conditions of difference in temperature shown in Table 1, flexible laminates were produced. The resulting flexible laminates exhibited large end waviness and poor appearance.

**Table 1**

| | | Example 1 | Example 2 | Example 3 | Comparative Example 1 | Comparative Example 2 |
|---|---|---|---|---|---|---|
| (Temperature of ends) - (Temperature of center portion) | °C | 60 | 40 | 20 | -20 | -40 |
| Degree of end waviness | | ⊚ | ○ | Δ | × | × |
| Width of waviness (W) | mm | 0 | 20 | 40 | 100 | 120 |
| Height of waviness (d) | mm | 0 | 1 | 1 | 4-6 | 5-7 |

### INDUSTRIAL APPLICABILITY

The laminate obtained by the method of producing a laminate of the present invention has good appearance and controlled end waviness. Thus, it is made possible to provide a heat-resistant flexible laminate which is particularly suited for use in the production of electronic and electric equipments.

## Claims

1. A method of producing a laminate (9), which comprises continuously laminating a heat-resistant film having thermal fusibility (2) withametallic foil (1) and cooling the laminate, **characterized in that** in the cooling process after lamination the temperature of the ends of the laminate is maintained the same as or higher than that of the center portion by a system having a mechanism capable of controlling the temperature of the center portion and the ends.

2. The method of producing a laminate according to claim 1, wherein in the cooling process the temperature of the ends is maintained 40°C higher than that of the center portion.

3. The method of producing a laminate according to claim 1 or 2, which comprises laminating using a heated roll laminating apparatus (4).

4. The method of producing a laminate according to claim 3, which comprises disposing a protective material (3) between the pressing surface of the heated roll laminating apparatus (4) and a laminating material, thermally laminating them at 200°C or higher, thereby to slightly contact the protective material with the laminating material, and removing the protective material from the laminate after cooling the laminate.

5. The method of producing a laminate according to any one of claims 1 to 4, wherein the heat-resistant filmhaving thermal fusibility (2) comprises a non-thermoplastic polyimide film and a resin containing a thermally fusible component provided on the surface of the non-thermoplastic polyimide film.

6. The method of producing a laminate according to any one of claims 1 to 5, wherein the thermally fusible component of the heat resistant film (2) contains a thermoplastic polyimide in an amount of 50% by weight or more based on 100% by weight of the thermally fusible component.

7. The method of producing a laminate according to any one of claims 1 to 6, wherein the metallic foil (1) is a copper foil having a thickness of 50 µm or less.

8. The method of producing a laminate according to any one of claims 1 to 7, wherein the protective material (3) is a non-thermoplastic polyimide film.

9. The method of producing a laminate according to any one of the preceding claims wherein the laminate is suitable for use as a flexible laminate for electronic and electric equipment.

10. A method of producing a laminate as claimed in any of the preceding claims wherein the temperature of the laminate center portion and ends is controlled during cooling by a heater system (7) capable of controlling temperature in a width direction.

## Patentansprüche

1. Verfahren zur Herstellung eines Laminats (9) umfassend kontinuierliches Laminieren eines hitzebeständigen Films (2), der thermische Schmelzfähigkeit aufweist, mit einer metallischen Folie (1) und Kühlen des Laminats, **dadurch gekennzeichnet, dass** beim Kühlen nach dem Laminieren die Temperatur der Enden des Laminats gleich oder höher gehalten wird als die Temperatur des zentralen Bereichs durch ein System, das einen Mechanismus aufweist, der die Temperatur des zentralen Bereichs und der Enden kontrollieren kann.

2. Das Verfahren zur Herstellung eines Laminats gemäß Anspruch 1, wobei beim Kühlen die Temperatur der Enden 40°C höher gehalten wird als die Temperatur des zentralen Bereichs.

3. Das Verfahren zur Herstellung eines Laminats gemäß Anspruch 1 oder 2, das ein Laminieren unter Verwendung einer Thermowalzen-Laminiermaschine (4) umfasst.

4. Das Verfahren zur Herstellung eines Laminats gemäß Anspruch 3, das ein Einlegen eines Schutzmaterials (3) zwischen die Pressoberfläche der Thermowalzen-Laminiermaschine (4) und einem Laminiermaterial umfasst, Laminieren derselben bei 200°C oder höher, wobei das Schutzmaterial mit dem Laminiermaterial geringfügig in Kontakt gebracht wird, und Entfernen des Schutzmaterials von dem Laminat nach dem Kühlen des Laminats.

5. Das Verfahren zur Herstellung eines Laminats gemäß einem der Ansprüche 1 bis 4, wobei der hitzebeständige Film mit thermischer Schmelzbarkeit (2) einen nicht-thermoplastischen Polyimidfilm und ein Harz umfasst, das eine thermisch schmelzbare Komponente auf der Oberfläche des nicht-thermoplastischen Polyimidfilms aufweist.

6. Das Verfahren zur Herstellung eines Laminats gemäß einem der Ansprüche 1 bis 5, worin die thermisch schmelzbare Komponente des hitzebeständigen Films (2) ein thermoplastisches Polyimid in einer Menge von 50 Gewichts-% oder mehr bezogen auf 100 Gewichts-% der thermisch schmelzbaren Komponente enthält.

7. Das Verfahren zur Herstellung eines Laminats gemäß einem der Ansprüche 1 bis 6, worin die metallische Folie (1) eine Kupferfolie mit einer Dicke von 50 µm oder weniger ist.

8. Das Verfahren zur Herstellung eines Laminats gemäß einem der Ansprüche 1 bis 7, wobei das Schutzmaterial (3) ein nicht-thermoplastischer Polyimidfilm ist.

9. Das Verfahren zur Herstellung eines Laminats gemäß einem der vorangehenden Ansprüche, wobei das Laminat geeignet ist zur Verwendung als flexibles Laminat für elektronische und elektrische Ausrüstung.

10. Verfahren zur Herstellung eines Laminats wie in einem der vorangehenden Ansprüche beansprucht, wobei die Temperatur des zentralen Bereichs des Laminats und der Enden beim Kühlen kontrolliert wird durch ein Heizsystem (7), das die Temperatur entlang der Breite kontrollieren kann.

## Revendications

1. Procédé de fabrication d'un laminé (9) qui comprend le laminage continu d'un film résistant à la chaleur ayant une fusibilité thermique (2) avec une feuille métallique (1) et le refroidissement du laminé, **caractérisé en ce que** dans le processus de refroidissement après le laminage, la température des extrémités du laminé est maintenue pour qu'elle soit identique ou plus élevée que celle de la portion centrale par un système ayant un mécanisme apte à commander la température de la portion centrale et des extrémités.

2. Procédé de fabrication d'un laminé selon la revendication 1, dans lequel dans le processus de refroidissement, la température des extrémités est maintenue à 40 °C plus élevée que celle de la portion centrale.

3. Procédé de fabrication d'un laminé selon la revendication 1 ou 2, qui comprend le laminage en utilisant un appareil de laminage à rouleaux chauffés (4).

4. Procédé de fabrication d'un laminé selon la revendication 3, qui comprend le placement d'un matériau de protection (3) entre la surface de pressage de l'appareil de laminage à rouleaux chauffés (4) et un matériau de laminage, le laminage thermique de ceux-ci à 200 °C ou plus élevée, pour amener ainsi le matériau de protection à venir légèrement en contact avec le matériau de laminage, et retirer le matériau de protection de laminé après le refroidissement du laminé.

5. Procédé de fabrication d'un laminé selon l'une quelconque des revendications 1 à 4, dans lequel le film résistant à la chaleur ayant une fusibilité thermique (2) comprend un film de polyimide non thermoplastique et une résine contenant un composant fusible thermiquement réalisé sur la surface du film de polyimide non-thermoplastique.

6. Procédé de fabrication d'un laminé selon l'une quelconque des revendications 1 à 5, dans lequel le composant fusible thermiquement du film résistant à la chaleur (2) contient un polyimide thermoplastique en une quantité de 50% en poids ou plus basée sur 100% en poids du composant thermiquement fusible.

7. Procédé de fabrication d'un laminé selon l'une quelconque des revendications 1 à 6, dans lequel la feuille métallique (1) est une feuille de cuivre d'une épaisseur de 50 µm ou moins.

8. Procédé de fabrication d'un laminé selon l'une quelconque des revendications 1 à 7, dans lequel le matériau de protection (3) est un film de polyimide non thermoplastique.

9. Procédé de fabrication d'un laminé selon l'une quelconque des revendications précédentes, dans lequel le laminé convient pour l'utilisation comme un laminé flexible pour un équipement électronique et électrique.

10. Procédé de fabrication d'un laminé selon l'une quelconque des revendications précédentes, dans lequel la température de la portion centrale et des extrémités du laminé est contrôlée durant le refroidissement par un système de chauffage (7) apte à contrôler la température dans une direction de largueur.
